(19) Europäisches Patentamt
European Patent Office
Office européen des brevets

(11) Veröffentlichungsnummer: **0 251 049 B1**

(12) # EUROPÄISCHE PATENTSCHRIFT

(45) Veröffentlichungstag der Patentschrift: **09.09.92**

(51) Int. Cl.$^5$: **G03F 7/105**

(21) Anmeldenummer: **87108757.3**

(22) Anmeldetag: **19.06.87**

(54) **Photopolymerisierbare Aufzeichnungsmaterialien sowie Photoresistschichten und Flachdruckplatten auf Basis dieser Aufzeichnungsmaterialien.**

(30) Priorität: **18.06.86 DE 3619792**

(43) Veröffentlichungstag der Anmeldung:
**07.01.88 Patentblatt 88/01**

(45) Bekanntmachung des Hinweises auf die Patenterteilung:
**09.09.92 Patentblatt 92/37**

(84) Benannte Vertragsstaaten:
**BE CH DE ES FR GB IT LI NL SE**

(56) Entgegenhaltungen:
**US-A- 3 549 367**
**US-A- 3 552 973**
**US-A- 4 447 520**
**US-A- 4 522 693**
**US-A- 4 710 523**

(73) Patentinhaber: **BASF Aktiengesellschaft**
**Carl-Bosch-Strasse 38**
**W-6700 Ludwigshafen(DE)**

(72) Erfinder: **Boettcher, Andreas, Dr.**
**Breslauer Strasse 24**
**W-6906 Leimen(DE)**
Erfinder: **Hofmann. Reiner, Dr.**
**Mandelbergstrasse 44**
**W-6730 Neustadt(DE)**
Erfinder: **Schupp, Hans, Dr.**
**Jean-Voelker-Strasse 40**
**W-6520 Worms 1(DE)**

EP 0 251 049 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft photopolymerisierbare Aufzeichnungsmaterialien mit mindestens einer photopolymerisierbaren, olefinisch ungesättigten organischen Verbindung, gegebenenfalls einem polymeren Bindemittel, einem Photopolymerisationsinitiator, einem farbbildenden System, bestehend aus Farbbildner und Photooxidationsmittel, sowie einem Sensibilisator. Sie sind insbesondere geeignet für die Herstellung von Photoresistschichten und Flachdruckplatten.

Photopolymerisierbare Aufzeichnungsmaterialien für die genannten Anwendungszwecke sind an sich bekannt. Sie enthalten im allgemeinen neben einer photopolymerisierbaren, olefinisch ungesättigten organischen Verbindung, einem polymeren Bindemittel sowie einem Photopolymerisationsinitiator ein farbbildendes System, welches bei Bestrahlung mit aktinischem Licht in den bestrahlten Bereichen eine Farbänderung bewirkt. Diese Farbänderung ist für die visuelle Beurteilung und Kontrolle der Aufzeichnungsmaterialien nach der bildmäßigen Belichtung von großer Wichtigkeit. So ist es z.B. bei der Herstellung gedruckter Schaltungen oder Leiterplatten mittels Photoresistschichten notwendig, sich nach der bildmäßigen Belichtung und vor der Entfernung der unbelichteten Bereiche der Photoresistschichten zu vergewissern, ob das Negativ richtig aufgelegt war. Ferner ermöglicht die Farbänderung bei der bildmäßigen Belichtung von Schichten aus den photopolymerisierbaren Aufzeichnungsmaterialien eine Kontrolle des erhaltenen Bildes nach der Entwicklung der belichteten Schicht, so daß hierdurch beispielsweise etwaige Ablösungen der Bildteile der Schicht bei der Entwicklung leicht und zuverlässig festgestellt werden können. Um eine gute visuelle Beurteilung dieser belichteten Schichten vornehmen zu können, soll das farbbildende System bei der Belichtung einen möglichst starken Farbkontrast in den Aufzeichnungsmaterialien bewirken, wobei durch diese Farbbildung möglichst dunkle Bilder bei Betrachtung im Gelblicht entstehen sollen. Ferner müssen die farbbildenden Systeme lagerstabil sein, damit in den photopolymerisierbaren Aufzeichnungsmaterialien in der Zeit zwischen Herstellung und Anwendung keine unerwünschte Farbvertiefung auftritt.

Die farbbildenden Systeme bestehen im allgemeinen aus einer farblosen oder schwach gefärbten Farbstoff-Vorstufe (Farbbildner) und einem Aktivator, der bei Bestrahlung mit aktinischem Licht die Farbstoff-Vorstufe in die farbige Verbindung überführt. Als Farbbildner kommen insbesondere Leukofarbstoffe oder die schwach gefärbten freien Basen oder Lactonformen von Farbstoffen in Betracht. Als Aktivatoren für die Farbbildner werden üblicherweise Photooxidationsmittel eingesetzt, wobei hierfür insbesondere organische Halogenverbindungen beschrieben werden, die bei Bestrahlung mit aktinischem Licht Halogenradikale abspalten. Verwiesen sei in diesem Zusammenhang z.B. auf die DE-A-23 06 353, DE-A-27 18 200, EP-B-2805, EP-B5379 sowie WO-A-80/01846. Es ist auch schon vorgeschlagen worden als Photooxidationsmittel Azidverbindungen, wie 2-Azidobenzoxazol, Benzoylazid und 2-Azidobenzimidazol (US-A-3 282 693), Triazole und heterocyclische Ketimide (GB 1 030 887) sowie Hexaarylbisimidazole zu verwenden (vgl. DE-A-19 24 317 sowie EP-B-19219). Die bekannten photopolymerisierbaren Aufzeichnungsmaterialien enthalten darüber hinaus in aller Regel zur Empfindlichkeitssteigerung und Verbesserung der Photoreaktion auch noch einen Sensibilisator, z.B. ein tertiäres Amin einer aromatischen Carbonylverbindung, wie z.B. Michler's Keton.

Die in den bekannten photopolymerisierbaren Aufzeichnungsmaterialien eingesetzten farbbildenden Systeme zeigen bei der bildmäßigen Belichtung dieser Materialien mit aktinischem Licht häufig nur einen schwachen Farbumschlag und einen nicht zufriedenstellenden Kontrast zwischen belichteten und unbelichteten Bereichen. Auch ist die Lagerstabilität der bisher für die photopolymerisierbaren Aufzeichnungsmaterialien verwendeten farbbildenden Systeme vielfach nicht zufriedenstellend, so daß bereits bei der Lagerung im Dunkeln eine Farbvertiefung zu beobachten ist. Die farbbildenden Systeme, die als Aktivator für den Farbbildner eine organische Halogenverbindung enthalten, beeinflussen ferner den Verarbeitungsspielraum der photopolymerisierbaren Aufzeichnungsmaterialien in negativer Weise. So lassen sich Photoresistschichten aus diesen Aufzeichnungsmaterialien beispielsweise nach der bildmäßigen Belichtung und Entwicklung nicht vollständig von metallischen Substraten entfernen, wie es z.B. bei der Herstellung von gedruckten Schaltungen und Leiterplatten erforderlich ist, sondern es verbleibt eine mehr oder weniger stark ausgebildete Resistschicht auf dem Substrat, die die Weiterverarbeitung der Produkte stört. Weiterhin kann der Halogengehalt zu Korrosionserscheinungen an metallischen Substraten führen. Die ferner auch verwendeten Hexaarylbisimidazole, die bei Bestrahlung der photopolymerisierbaren Aufzeichnungsmaterialien mit aktinischem Licht gleichermaßen die Photopolymerisation und die Photooxidation initiieren, sind nur in aufwendiger Weise herzustellen. Außerdem lassen sich bei dieser Verbindungsklasse Photopolymerisations- und -oxidationsverhalten in den photopolymerisierbaren Aufzeichnungsmaterialien ohne Verwendung weiterer Hilfsstoffe nicht unabhängig voneinander variieren. Es besteht daher ein Bedarf an weiteren, verbesserten farbbildenden Systemen für den Einsatz in photopolymerisierbaren Aufzeichnungsmaterialien der in Rede stehenden Art.

Aufgabe der vorliegenden Erfindung war es, photopolymerisierbare Aufzeichnungsmaterialien mit einem guten Farbbildner-System aufzuzeigen, die die Nachteile der bisher bekannten Produkte überwinden, d.h. die einfach und leicht erhältlich sind, bei den für die photopolymerisierbaren Aufzeichnungsmaterialien geforderten relativ kurzen Belichtungzeiten mit aktinischem Licht einen großen Farbumschlag unter Ausbildung eines scharfen und starken Kontrastes zwischen belichteten und unbelichteten Bereichen liefern, gute Lagerstabilität besitzen sowie auf metallischen Substraten keine Restschicht bilden.

Es wurde überraschenderweise gefunden, daß diese Aufgabe mit photopolymerisierbaren Aufzeichnungsmaterialien der eingangs beschriebenen Art gelöst wird, wenn das farbbildende System als Photooxidationsmittel für den Farbbildner eine Acylphosphinoxid- bzw. -sulfid-Verbindung enthält.

Gegenstand der Erfindung sind dementsprechend photopolymerisierbare Aufzeichnungsmaterialien mit mindestens einer photopolymerisierbaren, olefinisch ungesättigten organischen Verbindung, gegebenenfalls einem polymeren Bindemittel, mindestens einem Photopolymerisationsinitiator, einem farbbildenden System, welches bei Bestrahlung mit aktinischem Licht eine Zunahme der Farbintensität der Aufzeichnungsmaterialien bewirkt, einem Sensibilisator sowie gegebenenfalls weiteren Zusatz- und/oder Hilfsstoffen, die als farbbildendes System

a) mindestens eine farblose oder praktisch farblose organische Verbindung, die zu einer farbigen Verbindung oxidierbar ist und

(b) ein Photooxidationsmittel für die farblose oder praktisch farblose organische Verbindung (a) enthalten.

Die erfindungsgemäßen photopolymerisierbaren Aufzeichnungsmaterialien sind dadurch gekennzeichnet, daß sie als Photooxidationsmittel (b) eine Acylphosphinoxid- oder Acylphosphinsulfidverbindung enthalten mit der Maßgabe, daß das Maximum der langwelligen Absorptionsbande dieser Verbindung unter 500 nm liegt.

Derartige Acylphosphinoxid- und Acylphosphinsulfidverbindungen sind beispielsweise beschrieben in EP 0 007 508, EP 0 057 474, EP 0 047 902 und EP 0 073 413.

Bevorzugte photopolymerisierbare Aufzeichnungsmaterialien sind solche, die als Photooxidationsmittel (b) Acylphosphinoxid- oder Acylphosphinsulfidverbindungen der allgemeinen Formel (I) enthalten

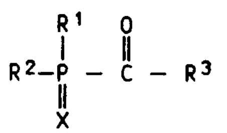

(I)

wobei $R^1$ für einen geradkettigen oder verzweigten Alkylrest mit 1 bis 6 Kohlenstoffatomen, einen Cyclohexyl-, Cyclopentyl-, Aryl-, einen halogen-, alkyl- oder alkoxyl-substituierten Aryl-, einen S- oder N-haltigen fünf- oder sechsgliedrigen heterocyclischen Rest steht, sowie für einen $C_1$- bis $C_6$-Alkoxyrest, einen $\alpha,\omega$-Hydroxyalkyloxyrest mit 1 bis 6 Kohlenstoffatomen in der Alkylgruppe, für einen Aryloxy- oder einen Arylalkoxyrest steht, und der Rest $R^1$ gegebenenfalls außerdem C-C-Doppelbindungen enthält, die es erlauben, das Photooxidationsmittel in das Bindemittel einzupolymerisieren,

$R^2$ die Bedeutung von $R^1$ hat, wobei $R^1$ und $R^2$ untereinander gleich oder verschieden sein können, oder für einen Alkoxyrest mit 1 bis 6 Kohlenstoffatomen, für einen Aryloxy- oder einen Arylalkoxyrest steht, oder $R^1$ und $R^2$ miteinander zu einem Ring verbunden sind;

$R^3$ für einen mindestens zweifach substituierten Phenyl-, Pyridyl-, Furyl- oder Thiophenyl-Rest steht, der mindestens an den beiden zur Verknüpfungsstelle mit der Carbonylgruppe benachbarten Kohlenstoffatomen die Substituenten A und B trägt, die untereinander gleich oder verschieden sein können, und für 1 bis 6 Kohlenstoffatome enthaltende Alkyl-, Alkoxy- oder Alkylthioreste, 5 bis 7 Kohlenstoffatome enthaltende Cycloalkylreste, Phenylreste oder Halogenatome stehen, oder $R^3$ für einen mindestens in den 2,8-Stellungen durch A und B substituierten $\alpha$-Naphthylrest oder mindestens in den 1,3-Stellungen durch A und B substituierten $\beta$-Naphthylrest steht,

sowie

X für Sauerstoff oder Schwefel steht.

Das Maximum der langwelligen Absorptionsbande dieser Verbindungen liegt unter 450 nm.

Als erfindungsgemäß im farbbildenden System der photopolymerisierbaren Aufzeichnungsmaterialien enthaltene Photooxidationmittel (b) kommen Acylphosphinoxide der oben gekennzeichneten Art in Frage. Bezüglich der Formel (I) ist im einzelnen folgendes auszuführen.

$R^1$, $R^2$ kann sein ein geradkettiger oder verzweigter Alkylrest mit 1 bis 6 C-Atomen, wie Methyl, Ethyl, n-Propyl, i-Propyl, n-Butyl, Amyl oder n-Hexyl, ein Cyclopentyl- oder Cyclohexylrest, ein Arylrest, wie Phenyl oder Naphthyl, ein halogensubstituierter Arylrest, wie Mono- oder Dichlorphenyl, ein alkylsubstituierter Arylrest, wie Methylphenyl, Ethylphenyl, Isopropylphenyl, tert.-Butylphenyl oder Dimethylphenyl, ein alkoxysubstituierter Arylrest, wie Methoxyphenyl, Ethoxyphenyl, Dimethoxyphenyl, ein S- oder N-haltiger fünf- oder sechsgliedriger heterocyclischer Rest, wie Thiophenyl oder Pyridyl. Ferner kann $R^1$, $R^2$ sein ein Alkoxylrest mit insbesondere 1 bis 6 C-Atomen, wie Methoxyl, Ethoxyl, i-Propoxyl, Butoxyl oder Ethoxyethoxyl, ein Aryloxyrest, wie Phenoxy oder Methylphenoxy, oder ein Arylalkoxyrest wie Benzyloxy.

$R^1$ und/oder $R^2$ können auch endständige, zum Einpolymerisieren geeignete funktionelle Gruppierungen, insbesondere C-C-Doppelbindungen enthalten. Derartige Gruppierungen sind z.B. Vinyl-, Allyl-, Acryloyl- oder Methacryloylgruppen.

$R^1$ kann mit $R^2$ auch zu einem Ring verbunden sein, wie z.B. in Acyl-phosphonsäure-o-phenylen-estern.

$R^3$ kann z.B. sein ein Phenyl- oder Naphthylrest, ein fünf- oder sechsgliedriger heterocyclischer Rest mit insbesondere S-, N- oder O-Ringatomen im Heterocyclus, z.B. ein Furyl-, Pyrrolyl-, Thienyl-, Pyranyl- oder Pyridylrest, der zumindest in den beiden ortho-Stellungen zur Carbonylgruppe die Substituenten A und B gebunden enthält.

Geeignete Substituenten A und B sind gegebenenfalls verzweigte Alkylreste mit insbesondere 1 bis 6, vorzugsweise 1 bis 4 Kohlenstoffatomen, wie Methyl, Ethyl, Propyl, iso-Propyl, Butyl, iso-Butyl und tert.-Butyl; gegebenenfalls substituierte Cycloalkylreste, wie Cyclohexyl, gegebenenfalls substituierte Arylreste, z.B. Phenyl oder Toluyl, Alkoxy- oder Alkylthioreste mit insbesondere 1 bis 6, vorzugsweise 1 bis 4 Kohlenstoffatomen, wie Methoxy, Ethoxy, Propoxy, iso-Propoxy, n-Butoxy, Methylthio, Ethylthio, Propylthio, iso-Propylthio, n-Butylthio, sec-Butylthio und tert.-Butylthio; Alkoxyalkylreste mit insbesondere 2 bis 12, vorzugsweise 2 bis 8 Kohlenstoffatomen, wie 2-Methoxyethyl oder tert.-Butoxy-2-propyl; Halogenatome, wie insbesondere ein Chlor- oder Bromatom.

Die $R^3$ gebunden enthaltenden Acylphosphinoxid-Verbindungen können beispielsweise durch die Strukturformel (III) bis (VI) veranschaulicht werden,

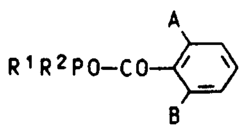
(III)

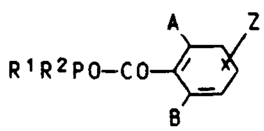
(IV)

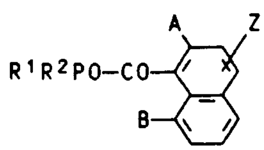
(V)

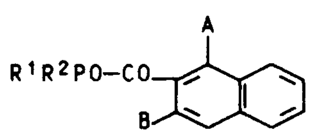
(VI)

wobei Z für gegebenenfalls weitere Substituenten in den Phenyl-, Naphthyl- oder heterocyclischen Resten steht, die die Bedeutung von A oder B haben.

Durch geeignete Auswahl der Substituenten in der allgemeinen Formel (I) lassen sich die Aktivität bei Bestrahlung mit aktinischem Licht und die Stabilität der erfindungsgemäß einzusetzenden Photooxidationsmittel (b) beeinflussen und variieren. Üblicher- und vorteilhafterweise wird das Photooxidationsmittel (b) so ausgewählt, daß dessen molarer Extinktionskoeffizient $\epsilon$ im Wellenlängenbereich von 330 bis 450 nm kleiner ist als der des in den erfindungsgemäßen photopolymerisierbaren Aufzeichnungsmaterialien mitverwendeten Sensibilisators für das Photooxidationsmittel (b) sowie gegebenenfalls des Photopolymerisationsinitiators.

Unter den erfindungsgemäß als Photooxidationsmittel (b) einzusetzenden Acylphosphinoxid- bzw. -sulfid-Verbindungen kommt den Derivaten der allgemeinen Formel (IV) besondere Bedeutung zu, wobei sich hier speziell die Verbindungen als besonders vorteilhaft erwiesen haben, in denen A, B und Z Alkyl-, insbesondere Methylgruppen sind.

Als Beispiele für Verbindungen, die erfindungsgemäß als Photooxidationsmittel (b) in den photopolymerisierbaren Aufzeichnungsmaterialien eingesetzt werden können, seien genannt:

2,4,6-Trimethylbenzoyldiphenylphospinoxid,
4-tert.-Butylbenzoyldiphenylphosphinoxid,
2,4,6-Trimethylbenzoyldiphenylphosphinsulfid,
2,4,6-Trimethylbenzoylditolylphosphinoxid,
2,4,6-Trimethylbenzoylditolylphosphinsulfid,
2,4,6-Trimethylbenzoyl-phenylphosphinsäureethylester,
2,4,6-Trimethylbenzoyl-phenylphosphinsäure-β-hydroxy-ethylester,
2,4,6-Trimethylbenzoyl-phenylphosphinsäureallylester und
2,4,6-Trimethylbenzoylphosphonsäurediethylester.

Die erfindungsgemäß als Photooxidationsmittel (b) einzusetzenden Verbindungen der vorstehend beschriebenen Art lassen sich nach üblichen und gängigen, literaturbekannten Verfahren oder in Analogie zu diesen herstellen. Verwiesen sei in diesem Zusammenhang z.B. auf die in J. Radiat. Cur. 10, 16 (1983) zitierte Literatur.

Das in den photopolymerisierbaren Aufzeichnungsmaterialien der Erfindung enthaltene farbbildende System, welches bei Bestrahlung der Aufzeichnungsmaterialien mit aktinischem Licht eine Zunahme der Farbintensität in diesen Materialien bewirkt, enthält neben den Photooxidationsmitteln (b) der vorstehend beschriebenen Art mindestens eine farblose oder praktisch farblose organische Verbindung (a), die zu einer farbigen Verbindung oxidierbar ist. Diese farbbildende, zunächst farblose oder praktisch farblose organische Verbindung (a) wird im folgenden auch als Farbbildner bezeichnet. Als Farbbildner (a) kommen insbesondere Leukofarbstoffe in Betracht, wobei unter Leukofarbstoff die reduzierte Form eines Farbstoffes verstanden wird, die im allgemeinen 1 bis 2 Wasserstoffatome aufweist, deren Entfernung gemeinsam mit einem oder zwei Elektronen zur Erzeugung des Farbstoffes führt. Diese Leukofarbstoffe sind im wesentlichen farblos oder weisen allenfalls eine geringe, wenig intensive Färbung auf, die von der Farbe des eigentlichen Farbstoffs (oxidierte Form) deutlich verschieden ist. Geeignete Leukofarbstoffe sind insbesondere die Diarylmethan- und Triarylmethan-Farbstoffe in ihrer Leukoform bzw. Farbstoffe mit einer Triarylmethan-Grundstruktur, bei denen zwei der Arylreste über ein N-, S- oder O-Atom miteinander verknüpft sind, in ihrer Leukoform. Hierzu gehören u.a. die Leukoformen der Aminoacridin-Farbstoffe, der Aminoxanthen-Farbstoffe und der Aminothioxanthen-Farbstoffe. Geeignet sind ebenfalls Leukofarbstoffe des Triarylmethan-Typs, bei denen ein Dialkyl- bzw. Alkyl-aryl-aminophenyl-Rest durch eine N-Alkyl-substituierte Carbazolyl-Gruppe ersetzt ist, wie sie beispielsweise in der US-A-4 154 463 beschrieben sind. Ferner können als Farbbildner (a) beispielsweise auch Leukomethine eingesetzt werden. Leukofarbstoffe, die als Farbbildner (a) für die erfindungsgemäßen photopolymerisierbaren Aufzeichnungsmaterialen geeignet sind, sind beispielsweise in der US-A-3 552 973 oder der DE-OS 34 33 026 beschrieben. Von besonderem Interesse sind dabei die Leukotriarylmethanfarbstoffe, wie z.B. Leukokristallviolett, Leukomalachitgrün, Leukobasischblau, Leukopararosanilin, Leukopatentblau A oder V.

Das Verhältnis von Farbbildner (a) und Photooxidationsmittel (b) in den photopolymerisierbaren Aufzeichnungsmaterialien ist so zu wählen, daß auf alle Fälle ein hinreichender Farbumschlag bei Belichtung mit aktinischem Licht bewirkt wird. Üblicherweise hat es sich als sinnvoll herausgestellt, das Photooxidationsmittel (b) in einem geringen Überschuß (gewichtsmäßig) im Vergleich zum Farbbildner (a) einzusetzen. Im übrigen werden Mengen und Mengenverhältnisse von Farbbildner (a) und Photooxidationsmittel (b) in der für den Fachmann üblichen und bekannten Weise so ausgewählt, daß die photopolymerisierbaren Aufzeichnungsmaterialien die an sie gestellten Anforderungen bezüglich Belichtungszeit, Farbkontrast etc. erfüllen.

Neben einem farbbildenden System der vorstehend beschriebenen Art enthalten die erfindungsgemäßen photopolymerisierbaren Aufzeichnungsmaterialien mindestens eine photopolymerisierbare, olefinisch ungesättigte organische Verbindung, gegebenenfalls ein polymeres Bindemittel, mindestens einen Photopolymerisationsinitiator, mindestens einen Sensibilisator sowie gegebenenfalls weitere Zusatz- und/oder Hilfsstoffe. Für diese weiteren Bestandteile der erfindungsgemäßen photopolymerisierbaren Aufzeichnungsmaterialien kommen die Verbindungen in Betracht, wie sie für die an sich bekannten photopolymerisierbaren Massen verwendet werden und beispielsweise in der eingangs zitierten Literatur beschrieben sind. Photopolymerisierbare Massen werden für die Herstellung von Überzügen, Druckplatten, Photoresistmaterialien und ähnlichen Zwecken eingesetzt.

Bei den photopolymerisierbaren, olefinisch ungesättigten organischen Verbindungen kann es sich um olefinisch ungesättigte Monomere, olefinisch ungesättigte Oligomere und/oder Polymere mit photopolymerisierbaren, olefinischen Doppelbindungen handeln. Die photopolymerisierbaren, olefinisch ungesättigten organischen Verbindungen enthalten vorzugsweise vinylische Doppelbindungen und insbesondere Vinyl-Gruppen, die durch Konjugation und/oder Nachbarschaftsstellung zu 0- oder N-Atomen aktiviert sind. Hierzu gehören insbesondere die Vinyl-Gruppen in Nachbarschaft zu Ester- oder Amidgruppen, wie z.B. die

Acryloyl- und Methacryloyl-Gruppierungen. Die photopolymerisierbaren, olefinisch ungesättigten organischen Verbindungen können sowohl mono- als auch polyfunktionell sein, d.h. sie können eine oder auch mehrere der photopolymerisierbaren olefinischen Doppelbindungen besitzen. Üblicherweise sind in den photopolymerisierbaren Aufzeichnungsmaterialien bi- oder mehrfunktionelle olefinisch ungesättigte, photopolymerisierbare Verbindungen allein oder Mischungen hiervon mit monofunktionellen olefinisch ungesättigten photopolymerisierbaren organischen Verbindungen enthalten. Die photopolymerisierbaren olefinisch ungesättigten Monomeren haben im allgemeinen ein Molekulargewicht unter 1 000. Das mittlere Molekulargewicht (Zahlenmittel) der photopolymerisierbaren olefinisch ungesättigten Oligomeren liegt vorzugsweise im Bereich von etwa 1 000 bis 10 000, insbesondere von etwa 1 500 bis 6 000. Das Molekulargewicht (Gewichtsmittel) der photopolymerisierbare, olefinische Doppelbindungen enthaltenden Polymeren liegt im allgemeinen über 15 000. Die photopolymerisierbaren, olefinisch ungesättigten organischen Verbindungen können allein oder auch in Mischung miteinander eingesetzt werden. Art und Menge der verwendeten photopolymerisierbaren, olefinisch ungesättigten organischen Verbindungen richten sich weitgehend nach dem Anwendungszweck der photopolymerisierbaren Aufzeichnungsmaterialien sowie nach der Art der weiteren mitverwendeten Bestandteile.

Als Vertreter für die photopolymerisierbaren Monomeren seien insbesondere die Derivate der (Meth)-acrylsäure und ganz besonders die (Meth)acrylsäureester genannt. Beispiele hierfür sind die Di- und Tri-(meth)acrylate von mehrwertigen Alkoholen, wie Ethylenglykol, Diethylenglykol, Triethylenglykol oder Polyethylenglykolen mit einem Molekulargewicht bis etwa 500, 1,2-Propandiol, 1,3-Propandiol, Polypropylenglykolen mit einem Molekulargewicht bis etwa 500, 1,4-Butandiol, 1,6-Hexandiol, 1,1,1-Trimethylolpropan, 2,2-Dimethylpropandiol, Glycerin oder Pentaerythrit; Pentaerythrittetra-(meth)acrylat, Glukosetri- oder tetra-(meth)acrylat; ferner die Monoacrylate und Monomethacrylate der genannten Diole und Polyole, wie z.B. Ethylenglykol-, Di-, Tri- oder Tetraethylenglykol-mono-(meth)acrylat, Propandiolmono-(meth)acrylat und Butandiol-mono-(meth)acrylat; sowie die (Meth)acrylate von Monoalkanolen, insbesondere von solchen mit 1 bis 20 C-Atomen. Neben den bevorzugten Acrylaten und Methacrylaten der vorstehend genannten Art seien als photopolymerisierbare Monomere auch die Allyl-Verbindungen und andere Vinyl-Verbindungen genannt, wie z.B. N-Vinylpyrrolidon, N-Vinylcaprolactam, Vinylacetat, Vinylpropionat, (Meth)acryl-amid, N-Methylol-(meth)acrylamid, der Bisether des Ethylenglykols und N-Methylol-(meth)acrylamids, Vinylcarbamate, Bisacrylamidoessigsäure, Glyoxalbisamid u.a.

Sehr geeignete photopolymerisierbare, olefinisch ungesättigte organische Verbindungen für die erfindungsgemäßen, photopolymerisierbaren Aufzeichnungsmaterialien sind auch die monomeren Urethanacrylate bzw. -methacrylate mit 2 oder mehr Acryloyl- und/oder Methacryloyl-Gruppen. Solche monomeren Urethan-(meth)acrylate können beispielsweise erhalten werden durch die Umsetzung von aliphatischen Di- oder Polyolen mit organischen Diisocyanaten in einem Äquivalentverhältnis OH:NCO von etwa 1:2 und anschließende Umsetzung der freien Isocyanatgruppen des erhaltenen Reaktionsproduktes mit geeigneten Acryloyl- und/oder Methacryloyl-Verbindungen, beispielsweise Hydroxyalkyl-(meth)acrylaten. Als aliphatische Di- und/oder Polyole kommen u.a. die vorstehend im Zusammenhang mit den Di- und Tri-(meth)-acrylaten genannten Di- und Polyhydroxy-Verbindungen in Betracht. Als Beispiele für organische Diisocyanate seien Hexamethylendiisocyanat, Toluylendiisocyanat, Isophorondiisocyanat und ähnliche genannt; Hydroxyalkyl(meth)acrylate sind beispielsweise Hydroxyethyl(meth)acrylat, Propandiol-mono-(meth)acrylat oder Butandiol-mono-(meth)acrylat. Ebenso geeignet und vorteilhaft sind Monomere mit 2 oder mehr Acryloyl- und/oder Methacryloyl-Gruppen, wie sie beispielsweise erhalten werden können durch Umsetzung von Di- oder Polyglycidylverbindungen mit Acrylsäure und/oder Methacrylsäure bzw. durch Umsetzung von Glycidyl(meth)acrylat mit Di- oder Polyolen, insbesondere aliphatischen Di- oder Polyolen, wie sie beispielsweise vorstehend im Zusammenhang mit den Di- und Tri(meth)acrylaten genannt sind. Als Di- und Polyglycidylverbindungen kommen hier insbesondere die Di- und Polyglycidylether mehrwertiger aliphatischer Alkohole oder mehrwertiger Phenole, beispielsweise des Bisphenols A oder der Substitutionsprodukte von Bisphenol A in Betracht. Beispielhaft für solche Acryloyl- und/oder Methacryloyl-Gruppen enthaltenden Monomeren seien die Umsetzungsprodukte des Bisphenol A-bisglycidylethers mit Acryl- und/oder Methacrylsäure im molaren Verhältnis von etwa 1:2 sowie das 1,6-Hexandiol-bis-glycidylether-bis-methacrylat genannt.

Als vorteilhaft, insbesondere für die Herstellung von Photoresistschichten, hat es sich erwiesen, wenn die photopolymerisierbaren Aufzeichnungsmaterialien als photopolymerisierbare, olefinisch ungesättigte organische Verbindung Oligomere mit 2 oder vorzugsweise mehr als zwei Acryloyl-und/oder Methacryloyl-Gruppen enthalten. Hierbei kann es sich beispielsweise um Acryloyl- und/oder Methacryloyl-Gruppen enthaltende oligomere Urethan-Harze oder um solche auf Basis von Di- oder Polyepoxiden handeln, wie sie als solche bekannt und in der Literatur beschrieben sind. Für wäßrig entwickelbare photopolymerisierbare Aufzeichnungsmaterialien sind hierbei solche Oligomeren der in Rede stehenden Art von besonderem

Interesse, die neben den Acryloyl- und/oder Methacryloyl-Gruppen zusätzlich noch freie Carboxylgruppen im Molekül enthalten. Der Anteil der freien Carboxylgruppen in diesen photopolymerisierbaren Oligomeren liegt dabei vorteilhafterweise so hoch, daß die Oligomeren eine Säurezahl im Bereich von 50 bis 150 mg KOH/g aufweisen. Geeignete photopolymerisierbare Oligomere dieser Art sind z.B. in der DE-A-24 42 527, der DE-C-25 57 408 oder auch der DE-A-29 17 483 beschrieben. Weitere photopolymerisierbare Oligomere, deren Einsatz in den erfindungsgemäßen photopolymerisierbaren Aufzeichnungsmaterialien sich als vorteilhaft herausgestellt hat, können beispielsweise hergestellt werden, indem man die freien Hydroxylgruppengruppen einer Acryloyl- und/oder Methacryloyl-Gruppen enthaltenden Diol- oder Polyolverbindung derart mit mehrfachen Carbonsäuren oder deren Derivaten, insbesondere cyclischen Carbonsäureanhydriden, umsetzt, daß sich die sauren Teilester der mehrfachen Carbonsäuren bilden, und anschließend einen Teil der freien Carboxylgruppen des so erhaltenen Reaktionsproduktes unter Kettenverlängerung sowie gegebenenfalls Verzweigung mit Di-und/oder Polyepoxiden umsetzt. Die Acryloyl- und/oder Methacryloyl-Gruppen enthaltenden Diol- oder Polyol-Verbindungen, die als Ausgangsprodukt für die Herstellung solcher Oligomeren dienen, werden zweckmäßigerweise hergestellt, indem man Di- oder Polyepoxid-Verbindungen, wie z.B. Di-oder Polyglycidylether bzw. Di- oder Polyglycidylester, mit Acrylsäure und/oder Methacrylsäure im Äquivalentverhältnis Glycidyl-Gruppen:COOH-Gruppen von etwa 1:1 umsetzt. Die Di- oder Polyepoxid-Verbindungen können dabei auch beispielsweise vor oder während der Umsetzung mit der (Meth)-acrylsäure durch Umsetzung mit Dicarbonsäuren vorverlängert werden. Beispielhaft und stellvertretend für solche Oligomeren der letztgenannten Art seien die Produkte genannt, wie sie erhältlich sind durch Umsetzung von Bisphenol A-bisglycidylether mit Acryl- und/oder Methacrylsäure bzw. mit einem Gemisch aus etwa 30 bis 70 Mol.% einer Dicarbonsäure, beispielsweise Adipinsäure, und etwa 30 bis 70 Mol.% Acryl- und/oder Methacrylsäure im Äquivalentverhältnis Glycidyl-Gruppen:Gesamt-COOH von 1:1, Umsetzung der Hydroxyl-Gruppen des so erhaltenen Reaktionsproduktes mit einem cyclischen Dicarbonsäureanhydrid, beispielsweise Phthalsäureanhydrid, gegebenenfalls in Mischung mit einem untergeordneten Anteil des Anhydrids einer anderen mehrfachen Carbonsäure, z.B. Trimellithsäureanhydrid, im Äquivalentverhältnis OH-Gruppen:Anhydrid-Gruppen von 1:1 unter Bildung der sauren Teilester der mehrfachen Carbonsäuren und schließlich Umsetzung eines Teils der freien Carboxyl-Gruppen des so erhaltenen Reaktionsproduktes mit einem Di- und/oder Polyglycidylether, beispielsweise Bisphenol A-bisglycidylether oder Pentaerythrittriglycidylether, im Äquivalentverhältnis COOH-Gruppen:Glycidylgruppen von > 1:1, vorzugsweise im Bereich von etwa 1,15:1 bis 5:1.

Als photopolymerisierbare olefinische Doppelbindungen enthaltende Polymere kommen beispielsweise solche lichtempfindlichen Polymeren in Betracht, wie sie z.B. in der DE-A-15 22 359 beschrieben sind.

Die photopolymerisierbaren, olefinisch ungesättigten organischen Verbindungen, die üblicherweise einen Siedepunkt von über 100 °C bei Atmosphärendruck aufweisen, sind dabei - für den Fachmann selbstverständlich - so zu wählen, daß sie mit den übrigen Bestandteilen der photopolymerisierbaren Aufzeichnungsmaterialien, insbesondere gegebenenfalls mitverwendeten polymeren Bindemitteln, verträglich sind.

Die bevorzugten photopolymerisierbaren Aufzeichnungsmaterialien enthalten neben den photopolymerisierbaren, olefinisch ungesättigten organischen Verbindungen polymere Bindemittel, insbesondere dann, wenn als photopolymerisierbare olefinisch ungesättigte organische Verbindungen ausschließlich photopolymerisierbare Monomere und/oder photopolymerisierbare Oligomere enthalten sind. Die polymeren Bindemittel sollen dabei in den Entwicklerlösungsmitteln für die photopolymerisierbaren Aufzeichnungsmaterialien löslich oder zumindest dispergierbar sein, um ein Auswaschen der unbelichteten und unvernetzten Anteile einer Schicht aus diesen Materialien nach einer bildmäßigen Belichtung mit aktinischem Licht zu ermöglichen. Als geeignete polymere Bindemittel seien genannt: lineare Polyamide und besonders alkohollösliche Copolyamide, wie sie in der FR-PS 1 520 856 beschrieben sind, Cellulosederivate, insbesondere wäßrigalkalisch auswaschbare Cellulosederivate, Vinylalkohol-Polymere und Polymere und Copolymere von Vinylestern aliphatischer Monocarbonsäuren mit 1 bis 4 C-Atomen, wie von Vinylacetat, mit unterschiedlichem Verseifungsgrad, Homo- und Copolymerisate des Vinylpyrrolidons, des Vinylchlorids oder des Styrols, Polyurethane, Polyetherurethane, Polyesterurethane, Polyesterharze, Dien-Polymere und -Copolymere, wie Blockcopolymerisate aus Butadien und/oder Isopren und Styrol oder $\alpha$-Methylstyrol, sowie, insbesondere für die Herstellung von Photoresistschichten und Flachdruckplatten, auch die Acrylsäurealkylester- und Methacrylsäurealkylester-Polymerisate und -Copolymerisate. Beispiele für geeignete und bevorzugte polymere Bindemittel sind u.a. Polymethacrylat, Polymethylmethacrylat, Alkyl-(meth)acrylat-Copolymerisate, die Amino-Gruppen enthaltende Comonomere, wie z.B. Dimethylaminoethylmethacrylat, einpolymerisiert enthalten, Copolymerisate von Alkyl(meth)acrylaten und (Meth)acrylsäure, die gegebenenfalls noch weitere Comonomere, wie z.B. N-Vinyllactame, Hydroxyalkyl(meth)acrylate oder Styrol, einpolymerisiert enthalten, Copolymerisate aus Styrol und Maleinsäureanhydrid und/oder Maleinsäurehalbester oder auch Copolymerisate von Styrol, Maleinsäureanhydrid und (Meth)acrylsäure.

Die erfindungsgemäßen photopolymerisierbaren Aufzeichnungsmaterialien enthalten ferner - zusätzlich zu dem Photooxidationsmittel (b) des farbbildenden Systems - als weitere lichtempfindliche Komponente mindestens einen Photopolymerisationsinitiator, der unter Einwirkung von aktinischem Licht die radikalische Polymerisation der photopolymerisierbaren olefinisch ungesättigten organischen Verbindungen in dem photopolymerisierbaren Aufzeichnungsmaterial zu initiieren vermag. Als besonders vorteilhaft haben sich hier die als Photoinitiator bekannten aromatischen Carbonylverbindungen erwiesen, insbesondere aromatische Ketone, die eine Struktureinheit der allgemeinen Formel (VII)

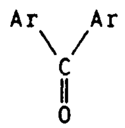

(VII)

aufweisen, worin Ar für einen gegebenenfalls substituierten Arylrest, insbesondere einen gegebenenfalls substituierten Phenylrest, steht. Die beiden Reste Ar in der Struktureinheit der allgemeinen Formel (VII) können dabei gleich oder verschieden sein sowie gegebenenfalls auch, beispielsweise über eine -CH-Gruppe oder ein -S-Atom, miteinander verknüpft sein. Bevorzugt werden die Photopolymerisationsinitiatoren so ausgewählt, daß sie keine starke Absorption ($\epsilon < 5000$) in dem Wellenlängenbereich des aktinischen Lichts haben, in dem die in den erfindungsgemäßen photopolymerisierbaren Aufzeichnungsmaterialien enthaltenen Sensibilisatoren ihre Absorptionsbande(n) haben. Es ist weiterhin bekannt (siehe z.B. J. Radiat. Cur. 13, 4 (1986)), daß die Photopolymerisationsinitiatoren des geannten Typs auch in Kombination mit Aminen eingesetzt werden können. Als Beispiele für bevorzugte Photopolymerisationsinitiatoren seien genannt Benzophenon, substituierte Benzophenone, wie 4,4'-Dichlorbenzophenon, mehrkernige unsubstituierte oder substituierte Chinone, wie Anthrachinon, Benzanthrachinon, 2-Ethylanthrachinon oder tert.-Butylanthrachinon,sowie Thioxanthone, wie z.B. 2-Methyl-, 2-Isopropyl- oder 2-Chlor-thioxanthon.

Die erfindungsgemäßen photopolymerisierbaren Aufzeichnungsmaterialien enthalten darüber hinaus mindestens einen Sensibilisator im weiteren Sinne, d.h. eine Verbindung, die bei Bestrahlung der photopolymerisierbaren Aufzeichnungsmaterialien mit aktinischem Licht das Photooxidationsmittel (b) und/oder den Photopolymerisationsinitiator aktiviert. Als Sensibilisatoren für die erfindungsgemäßen photopolymerisierbaren Aufzeichnungsmaterialien kommen insbesondere elektronenreiche aromatische Verbindungen in Betracht. Vorzugsweise werden als Sensibilisatoren tertiäre aromatische Amine eingesetzt, insbesondere solche, in denen der Aminophenylrest mit einem Carbonylrest, insbesondere einem aromatischen Carbonylrest so verbunden ist, daß die Doppelbindungen miteinander in Konjugation stehen. Hierzu gehören beispielsweise aromatische Amine der allgemeinen Formel (II)

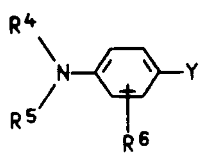

(II)

worin $R^4$ und $R^5$ gleich oder verschieden sein können und eine Alkyl-Gruppe, beispielsweise Methyl oder Ethyl, eine Hydroxyalkyl, eine Phenyl-Gruppe oder eine Aralkyl-Gruppe, beispielsweise Benzyl, darstellen oder $R^4$ und $R^5$ über einen /Ring miteinander verbunden sind, $R^6$ ein Wasserstoffatom oder eine Alkylgruppe darstellt und Y für einen, vorzugsweise substituierten, Benzoylrest des Typs

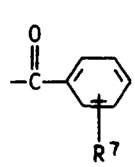

mit $R^7$ = H, Alkyl, Cycloalkyl, Hydroxyalkyl, Cl, Br, Alkoxy, Alkylthio, Dialkylamino oder Diarylamino, vorzugsweise in p-Stellung, steht.

Bevorzugte Sensibilisatoren für die erfindungsgemäßen photopolymerisierbaren Aufzeichnungsmaterialien sind solche der allgemeinen Formel (II), worin X eine der folgenden Bedeutungen hat:

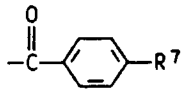

$R^7$ = Dialkylamino oder Diarylamino.

Als Beispiele für geeignete und bevorzugte Sensibilisatoren seien u.a. 4-Dimethylaminobenzophenon, 4,4'-Bis(dimethylamino)-benzophenon, 4,4'-Bis(diethylamino)-benzophenon und 4,4'-Bis-(hydroxyethylmethylamino)benzophenon genannt.

Das farbbildende System mit den erfindungsgemäß einzusetzenden Photooxidationsmitteln (b) bewirkt dabei überraschenderweise in den erfindungsgemäßen photopolymerisierbaren Aufzeichnungsmaterialien mit den Sensibilisatoren der vorstehend beschriebenen Art eine sehr starke Vertiefung der Farbintensität und Kontrastbildung schon bei den relativ kurzen Belichtungszeiten mit aktinischem Licht, wie sie für die photopolymerisierbaren Aufzeichnungsmaterialien gefordert werden.

Neben den genannten Bestandteilen können die erfindungsgemäßen photopolymerisierbaren Aufzeichnungsmaterialien noch weitere, übliche, die verarbeitungs- und/oder anwendungstechnischen Eigenschaften der Aufzeichnungsmaterialien verbessernde und/oder modifizierende Zusatz- und/oder Hilfsstoffe enthalten. Hierzu gehören u.a. thermische Polymerisationsinhibitoren, anorganische oder organische Pigmente oder Farbstoffe, die sowohl als Kontrastmittel als auch schichtverfestigend wirken können, niedermolekulare Haftvermittler, Verlaufshilfsmittel, Mattierungs- oder Gleitmittel, Weichmacher und dgl.

Die Bestandteile der erfindungsgemäßen photopolymerisierbaren Aufzeichnungsmaterialien werden in den für sie üblichen und an sich bekannten Mengen und Mengenverhältnissen eingesetzt und liegen in den Aufzeichnungsmaterialien in homogener Mischung vor. Zur Herstellung der photopolymerisierbaren Aufzeichnungsmaterialien werden die Bestandteile nach den an sich bekannten Verfahren homogen miteinander vermischt, beispielsweise in Lösung in einem geeigneten Lösungsmittel oder Lösungsmittelgemisch oder in einer Mischvorrichtung, wie einem Kneter, Extruder oder dgl. Vorzugsweise werden Art und Menge der einzelnen Bestandteile der erfindungsgemäßen photopolymerisierbaren Aufzeichnungsmaterialien so aufeinander abgestimmt, daß die resultierende Mischung - sofern die Mischung in Lösung hergestellt wurde, nach Entfernung des Lösungsmittels - fest ist.

Zum Auslösen der Photopolymerisation und der Farbbildung bzw. der Vertiefung der Farbintensität in den erfindungsgemäßen photopolymerisierbaren Aufzeichnungsmaterialien dient aktinisches Licht einer Wellenlänge von 300 bis 420 nm, insbesondere solches im Wellenlängenbereich von 320 bis 400 nm. Als Strahlungsquellen sind u.a. Quecksilberhochdrucklampen, Quecksilbermitteldrucklampen, Quecksilberniederdrucklampen, superaktinische Leuchtstoffröhren, Xenon-Impulslampen, UV-Fluoreszenzröhren und dgl. geeignet.

Die erfindungsgemäßen Aufzeichnungsmaterialien können in an sich bekannter Weise zu UV-härtbaren Überzügen, Photopolymerdruckplatten jeder Art, Reliefformen, Photoresists und dgl. verarbeitet werden. Besonders vorteilhaft sind sie dort, wo bei der Bestrahlung mit aktinischem Licht neben einer guten Photopolymerisation in den belichteten Bereichen auch eine möglichst große Änderung der Farbintensität und ein möglichst großer Farbkontrast gewünscht wird, wie beispielsweise in lichtempfindlichen Aufzeichnungselementen mit einer auf einem Trägermaterial aufgebrachten dünnen Schicht aus den erfindungsgemäßen photopolymerisierbaren Aufzeichnungsmaterialien, insbesondere Trockenfilmresists für die trockene Schichtübertragung und Flachdruckplatten. Als Trägermaterialien für diese lichtempfindlichen Aufzeichnungselemente kommen die hierfür üblichen dimensionsstabilen, vorzugsweise biegsamen, Materialien, wie Kunststofffilme oder -folien und Metallbleche, in Betracht. Für Trockenfilmresists haben sich als Träger insbesondere Polyesterfolien, beispielsweise aus Polyethylenterephthalat oder Polybutylenterephthalat, bewährt. Für Flachdruckplatten finden als Trägermaterialien insbesondere die offsettypischen Aluminiumbleche Anwendung, deren Oberfläche in an sich bekannter Weise mechanisch, chemisch und/oder elektrochemisch aufgerauht und vorbehandelt ist. Die dünne Schicht aus den erfindungsgemäßen photopolymerisierbaren Aufzeichnungsmaterialien, die für Trockenfilmresists üblicherweise im Bereich von etwa 10 bis 100 µm, insbesondere im Bereich von etwa 15 bis 70 µm, und für Flachdruckplatten üblicherweise im Bereich von etwa 1 bis 6 µm liegt, wird auf die Trägermaterialien nach bekannten Auftragstechniken, beispielsweise durch Gießen aus Lösung, spin coating oder dgl., aufgebracht.

Für die Herstellung von Flachdruckformen werden die mit den erfindungsgemäßen photopolymerisierbaren Aufzeichnungsmaterialien hergestellten Flachdruckplatten in üblicher Weise bildmäßig mit aktinischem Licht belichtet und durch Auswaschen mit einem geeigneten Entwicklerlösungsmittel entwickelt. Zur Herstellung von bildmäßig strukturierten Resistmustern wird das erfindungsgemäße photopolymerisierbare Aufzeichnungsmaterial schichtförmig auf das zu schützende, sowie gegebenenfalls dauerhaft zu modifizierende Substrat, entweder direkt, beispielsweise aus Lösung, oder durch Auflaminieren einer vorgefertigten Schicht nach dem Schichtübertragungsverfahren mittels eines Trockenfilmresists, aufgebracht. Als Substrat, dessen Art sich bekanntermaßen nach dem jeweiligen Anwendungszweck des herzustellenden Resistmusters richtet, kommen die in diesem Bereich üblichen und bekannten Materialien, wie z.B. Kupferbleche oder kupferkaschierte Basismaterialien oder Aluminiumbleche, in Betracht. Zur Erzeugung des bildmäßig strukturierten Resistmusters wird die auf das Substrat aufgebrachte Photoresistschicht aus den erfindungsgemäßen photopolymerisierbaren Aufzeichnungsmaterialien bildmäßig mit aktinischem Licht belichtet und anschließend unter Entfernen der unbelichteten Schichtbereiche mit einem geeigneten Entwicklerlösungsmittel ausgewaschen. Für die bildmäßige Belichtung der erfindungsgemäßen photopolymerisierbaren Aufzeichnungsmaterialien kommt aktinisches Licht in dem vorstehend genannten Wellenlängenbereich in Betracht. Die Art des Entwicklerlösungsmittels richtet sich nach den für den Aufbau der erfindungsgemäßen photopolymerisierbaren Aufzeichnungsmaterialien verwendeten Bestandteile, insbesondere dem eingesetzten polymeren Bindemittel und/oder den photopolymerisierbaren, olefinisch ungesättigten organischen Verbindungen. Danach können sowohl organische Lösungsmittel oder Lösungsmittelgemische wie auch wäßrige Entwicklerlösungen zur Anwendung kommen.

Das farbbildende System in den erfindungsgemäßen photopolymerisierbaren Aufzeichnungsmaterialien besitzt eine hohe Stabilität. Die photopolymerisierbaren Aufzeichnungsmaterialien weisen daher eine ausgezeichnete Dunkellagerfähigkeit auf, ohne daß es hierzu des Zusatzes großer Mengen eines thermischen Inhibitors bedarf, wie er bei den Produkten nach dem Stand der Technik erforderlich ist. Bei der Belichtung mit aktinischem Licht zeigen die erfindungsgemäßen photopolymerisierbaren Aufzeichnungsmaterialien,die in ihrem farbbildenden System die erfindungsgemäß einzusetzenden, leicht zugänglichen Photooxidationsmittel enthalten, eine unerwartet große Zunahme der Farbintensität und einen stärkeren Farbkontrast zwischen belichteten und unbelichteten Bereichen, als er bei anderen dem Stand der Technik entsprechenden bekannten Produkten erzielt wird. Es ist dem Fachmann bekannt, daß die im farbbildenden System bei der Bestrahlung mit aktinischem Licht erzeugten Radikale nicht nur die Oxidation eines Leukofarbstoffs initiieren, sondern auch in dem parallel ablaufenden, durch den Polymerisationsinitiator eingeleiteten Polymerisationsprozeß abgefangen werden können. Es war völlig überraschend, daß die aus dem Stand der Technik als Polymerisationsinitiatoren bekannten erfindungsgemäßen Acylphosphinoxide und -sulfide in Gegenwart eines Leukofarbstoffes deutlich bevorzugt die Photooxidation begünstigen.

Die Verwendung der erfindungsgemäß einzusetzenden Photooxidationsmittel in den photopolymerisierbaren Aufzeichnungsmaterialien hat dabei keinen nachteiligen Einfluß auf die anderen, für die Herstellung und Verwendung dieser Aufzeichnungsmaterialien wichtigen anwendungstechnischen Eigenschaften. Darüber hinaus wird mit den erfindungsgemäßen photopolymerisierbaren Aufzeichnungsmaterialien überraschenderweise auch das Restschicht-Problem überwunden, d.h. die aus den erfindungsgemäßen photopolymerisierbaren Aufzeichnungsmaterialien hergestellten, bildmäßig belichteten und entwickelten Schichten lassen sich von dem Substrat auch nach längerer Zeit wieder vollständig und und ohne Rückstand durch Strippen mit einem Lösungsmittel entfernen. Dies ist insbesondere für die Verwendung als Photoresist, z.B. bei der Herstellung von Leiterplatten und integrierten Schaltungen, von großer Bedeutung.

Die Erfindung wird durch die nachfolgenden Beispiele näher erläutert. Die in den Beispielen und Vergleichsversuchen genannten Teile und Prozente beziehen sich, sofern nicht ander angegeben, auf das Gewicht.

Beispiel 1

Photooxidation von Leukokristallviolett (= KVL)

Eine Lösung von 0,5 % KVL und 1 % Photoinitiator wurde 5 Minuten in einem handelsüblichen Röhrenflachbelichter bestrahlt und die optische Dichte (OD) der Mischung vor und nach der Belichtung bei 590 nm gemessen.

| Photoinitiator/ Photooxidans | Optische Dichte vor der Belichtung | Optische Dichte nach der Belichtung | Δ OD |
|---|---|---|---|
| Benzoinisopropylether | 0,25 | 0,26 | 0,01 |
| Azoisobutyronitril | 0,30 | 0,71 | 0,41 |
| BP / MK (1 % / 0,4 %) | 0,29 | 0,38 | 0,09 |
| HABI | 0,45 | 2,58 | 2,13 |
| TMDPO | 0,35 | 2,76 | 2,41 |

BP: Benzophenon;
MK: 4,4'-Bis(dimethylamino)benzophenon;
HABI: Dimeres des 2-(2-Chlorphenyl)-4,5-diphenyl-imidazolyl-Radikals;
TMDPO: 2,4,6-Trimethylbenzoyldiphenylphosphinoxid

Beispiel 2

Bestimmung des Anteils der konkurrierenden Reaktionen Photopolymerisation/Photooxidation:

Es wurde zunächst eine Lösung von Typ A, enthaltend
1 % Photoinitiator bzw. Photooxidans und
0,5 % KVL in Essigester
hergestellt und die Änderung der optischen Dichte nach 2 Minuten Belichtung im handelsüblichen Röhrenflachbelichter gemessen. Anschließend wurden die Experimente mit einer Lösung vom Typ B, enthaltend
1 % Photoinitiator bzw. Photooxidans,
0,5 % KVL und
20 % Methylmethacrylat (= MMA) in Essigester
wiederholt. Aus dem Verhältnis der Änderungen der optischen Dichten konnte die Relation Photopolymerisation/Photooxidation abgeschätzt werden. Es wurde gefunden:

| Photoinitiator/ Photooxidans | Änderung der optischen Dichte mit MMA | Änderung der optischen Dichte ohne MMA | Photopolymerisation | Photooxidation |
|---|---|---|---|---|
| MK/BP/HCX* | 0,91 | 1,37 | 34 % | 66 % |
| HABI | 0,55 | 0,96 | 43 % | 57 % |
| TMDPO | 1,01 | 1,21 | 17 % | 83 % |

* MK/BP/HCX = 0,04 % /1 % /1 %;
HCX: 2,5-Dichlor-1,4-bis(dichlormethyl)benzol
Das Initiatorsystem MK/BP/HCX ist Stand der Technik nach DE-OS 27 59 164

Beispiel 3

Bestimmung der Photooxidation von KVL und des Polymerisationsgrades in photopolymerisierbaren Aufzeichnungsmaterialien.

Ein Gemisch, bestehend aus

| | |
|---|---|
| 53 % | Basispolymeres (= Polymethylmethacrylat; K-Wert nach Fikentscher: 40) |
| 17 % | Trimethylolpropantriacrylat |
| 13 % | Umsetzungsprodukt von Bisphenol A-diglycidylether mit Acrylsäure im Molverhältnis 1:2 |
| 7 % | TMDPO |
| 0,5 % | KVL |
| 3 % | Weichmacher (Tetraethylenglykoldiacetat) |
| 6,5 % | weitere übliche Zusatzstoffe (Inhibitor, Aktivator, Farbstoff) für lichtempfindliche Aufzeichnungsmaterialien |

wurde auf eine Glasplatte aufgerakelt und nach dem Trocknen in einem handelsüblichen Röhrenflachbelichter durch eine Prüfmaske belichtet und die Änderung der optischen Dichte bei 590 nm gemessen.

Zum Vergleich wurde in zwei weiteren Ansätzen mit der gleichen Rezeptur anteilsmäßig unter Beibehaltung der TMDPO-Konzentration Michler's Keton (= MK) (0,13 %) bzw. MK/BP (0,13 %/3,4 %) zugemischt und wie oben beschrieben geprüft.

| Photooxidans | Polymerisationsinitiator | Änderung der optischen Dichte | Taktzahl* |
|---|---|---|---|
| TMDPO | - | 0.09 | 19 |
| MK/TMDPO | - | 0,14 | 18 |
| MK/TMDPO | MK/BP | 0,14 | 14 |

*Taktzahl: Maß für die Lichtintensität, die erforderlich ist, um einen dem Stand der Technik entsprechenden Polymerisationsgrad zu erzielen.

## Patentansprüche

## Patentansprüche fur folgende Vertragsstaaten : BE, CH, DE, FR, GB, IT, LI, NL, SE

**1.** Photopolymerisierbare Aufzeichnungsmaterialien mit mindestens einer photopolymerisierbaren, olefinisch ungesättigten organischen Verbindung, gegebenenfalls einem polymeren Bindemittel, mindestens einem Photopolymerisationsinitiator, einem farbbildenden System, welches bei Bestrahlung mit aktinischem Licht eine Zunahme der Farbintensität der Aufzeichnungsmaterialien bewirkt, einem Sensibilisator sowie gegebenenfalls weiteren Zusatz- und/oder Hilfsstoffen, die als farbbildendes System

(a) mindestens eine farblose oder praktisch farblose organische Verbindung, die zu einer farbigen Verbindung oxidierbar ist, und

(b) ein Photooxidationsmittel für die farblose oder praktisch farblose organische Verbindung (a) enthalten,

dadurch gekennzeichnet, daß sie als Photooxidationsmittel (b) eine Acylphosphinoxid- oder Acylphosphinsulfidverbindung enthalten, mit der Maßgabe, daß das Maximum der langwelligen Absorptionsbande dieser Verbindung unter 500 nm liegt.

**2.** Photopolymerisierbare Aufzeichnungsmaterialien nach Anspruch 1, dadurch gekennzeichnet, daß sie als Photoxidationsmittel (b) Acylphosphinoxid- oder Acylphosphinsulfidverbindungen der allgemeinen Formel (I) enthalten,

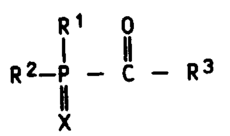

(I)

wobei $R^1$ für einen geradkettigen oder verzweigten Alkylrest mit 1 bis 6 Kohlenstoffatomen, einen Cyclohexyl-, Cyclopentyl-, Aryl-, einen halogen-, alkyl- oder alkoxyl-substituierten Aryl-, einen S- oder N-haltigen fünf- oder sechsgliedrigen heterocyclischen Rest steht, sowie für einen $C_1$- bis $C_6$-Alkoxyrest, einen $\alpha,\omega$-Hydroxyalkyloxyrest mit 1 bis 6 Kohlenstoffatomen in der Alkylgruppe, für einen

Aryloxy- oder einen Arylalkoxyrest steht, und der Rest $R^1$ gegebenenfalls außerdem C-C-Doppelbindungen enthält, die es erlauben, das Photooxidationsmittel in das Bindemittel einzupolymerisieren,

$R^2$ die Bedeutung von $R^1$ hat, wobei $R^1$ und $R^2$ untereinander gleich oder verschieden sein können, oder für einen Alkoxyrest mit 1 bis 6 Kohlenstoffatomen, für einen Aryloxy- oder einen Arylalkoxyrest steht, oder $R^1$ und $R^2$ miteinander zu einem Ring verbunden sind;

$R^3$ für einen mindestens zweifach substituierten Phenyl-, Pyridyl-, Furyl- oder Thiophenyl-Rest steht, der mindestens an den beiden zur Verknüpfungsstelle mit der Carbonylgruppe benachbarten Kohlenstoffatomen die Substituenten A und B trägt, die untereinander gleich oder verschieden sein können, und für 1 bis 6 Kohlenstoffatome enthaltende Alkyl-, Alkoxy- oder Alkylthioreste, 5 bis 7 Kohlenstoffatome enthaltende Cycloalkylreste, Phenylreste oder Halogenatome stehen, oder $R^3$ für einen mindestens in den 2,8-Stellungen durch A und B substituierten $\alpha$-Naphthylrest oder mindestens in den 1,3-Stellungen durch A und B substituierten $\beta$-Naphthylrest steht,

sowie

X für Sauerstoff oder Schwefel steht.

**3.** Photopolymerisierbare Aufzeichnungsmaterialien nach Anspruch 1 oder 2, dadurch gekennzeichnet, daß in der allgemeinen Formel (I) des Photooxidationsmittels (b) $R^3$ ein 2,4,6-Trimethylphenyl-, 2,3,6-Trimethylphenyl-, 2,6-Dimethoxyphenyl-, 2,6-Dichlorphenyl-, 2,6-Di-(methylthio)-phenyl- oder ein 2,3,5,6-Tetramethylphenylrest ist.

**4.** Photopolymerisierbare Aufzeichnungsmaterialien nach einem der Ansprüche 1 oder 2, dadurch gekennzeichnet, daß $R^3$ ein 2,4,6-Trimethylpyridyl-3- oder ein 2,4-Dimethylthiophenyl-3-Rest ist.

**5.** Photopolymerisierbare Aufzeichnungsmaterialien nach einem der Ansprüche 1 oder 2, dadurch gekennzeichnet, daß $R^3$ ein 1,3-Dimethyl-naphthalin-2-,ein 2,8-Dimethyl-naphthalin-1-, ein 1,3-Dimethoxy-naphthalin-2- oder ein 2,8-Dimethoxynaphthalin-1-Rest ist.

**6.** Photopolymerisierbare Aufzeichnungsmaterialien nach einem der Ansprüche 1 bis 5, dadurch gekennzeichnet, daß $R^1$ und $R^2$ die Bedeutung Phenyl oder $C_1$- bis $C_6$-Alkyl-substituiertes Phenyl haben.

**7.** Photopolymerisierbare Aufzeichnungsmaterialien nach einem der Ansprüche 1 bis 6, dadurch gekennzeichnet, daß sie als farblose oder praktisch farblose organische Verbindung (a), die zu einer farbigen Verbindung oxidierbar ist, einen Leukofarbstoff, insbesondere einen Triarylmethanfarbstoff in seiner Leukoform enthalten.

**8.** Photopolymerisierbare Aufzeichnungsmaterialien nach einem der Ansprüche 1 bis 7, dadurch gekennzeichnet, daß sie als Photopolymerisationsinitiator eine aromatische Carbonylverbindung, insbesondere Benzophenon oder ein Benzophenon-Derivat, enthalten.

**9.** Photopolymerisierbare Aufzeichnungsmaterialien nach einem der Ansprüche 1 bis 8, dadurch gekennzeichnet, daß sie als Sensibilisator ein tertäres aromatisches Amin enthalten, bei dem der die tertiäre Amino-Gruppe tragende aromatische Ring mit einem weiteren aromatischen Ring über Konjugation miteinander verbunden ist.

**10.** Photopolymerisierbare Aufzeichnungsmaterialien nach Anspruch 9, dadurch gekennzeichnet, daß sie als Sensibilisator eine Verbindung der allgemeinen Formel (II)

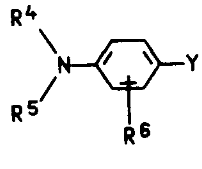

(II)

enthalten, worin

$R^4$ und $R^5$ gleich oder verschieden sein können und stehen für eine Alkylgruppe, eine Phenylgruppe, eine Aralkyl-Gruppe oder eine Hydroxyalkyl-Gruppe,

$R^6$ steht für ein Wasserstoffatom oder eine Alkylgruppe und
Y steht für einen gegebenenfalls substituierten Benzoylrest.

**11.** Photoresistschichten auf Basis von photopolymerisierbaren Aufzeichnungsmaterialien nach einem der Ansprüche 1 bis 10.

**12.** Flachdruckplatten auf Basis von photopolymerisierbaren Aufzeichnungsmaterialien nach einem der Ansprüche 1 bis 10.

**Patentansprüche für folgenden Vertragsstaat : ES**

**1.** Verfahren zur Herstellung photopolymerisierbarer Aufzeichnungsmaterialien aus mindestens einer photopolymerisierbaren, olefinisch ungesättigten organischen Verbindung, gegebenenfalls einem polymeren Bindemittel, mindestens einem Photopolymerisationsinitiator, einem farbbildenden System, welches bei Bestrahlung mit aktinischem Licht eine Zunahme der Farbintensität der Aufzeichnungsmaterialien bewirkt, einem Sensibilisator sowie gegebenenfalls weiteren Zusatz- und/oder Hilfsstoffen, die als farbbildendes System
(a) mindestens eine farblose oder praktisch farblose organische Verbindung, die zu einer farbigen Verbindung oxidierbar ist, und
(b) ein Photooxidationsmittel für die farblose oder praktisch farblose organische Verbindung (a) enthalten,
dadurch gekennzeichnet, daß als Photooxidationsmittel (b) eine Acylphosphinoxid- oder Acylphosphinsulfidverbindung eingesetzt wird, mit der Maßgabe, daß das Maximum der langwelligen Absorptionsbande dieser Verbindung unter 500 nm liegt.

**2.** Verfahren nach Anspruch 1, dadurch gekennzeichnet, daß als Photoxidationsmittel (b) Acylphosphinoxid- oder Acylphosphinsulfidverbindungen der allgemeinen Formel (I) eingesetzt werden,

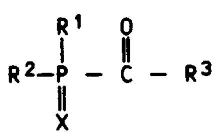
(I)

wobei $R^1$ für einen geradkettigen oder verzweigten Alkylrest mit 1 bis 6 Kohlenstoffatomen, einen Cyclohexyl-, Cyclopentyl-, Aryl-, einen halogen-, alkyl- oder alkoxyl-substituierten Aryl-, einen S- oder N-haltigen fünf- oder sechsgliedrigen heterocyclischen Rest steht, sowie für einen $C_1$- bis $C_6$-Alkoxyrest, einen $\alpha,\omega$-Hydroxyalkyloxyrest mit 1 bis 6 Kohlenstoffatomen in der Alkylgruppe, für einen Aryloxy- oder einen Arylalkoxyrest steht, und der Rest $R^1$ gegebenenfalls außerdem C-C-Doppelbindungen enthält, die es erlauben, das Photooxidationsmittel in das Bindemittel einzupolymerisieren,
$R^2$ die Bedeutung von $R^1$ hat, wobei $R^1$ und $R^2$ untereinander gleich oder verschieden sein können, oder für einen Alkoxyrest mit 1 bis 6 Kohlenstoffatomen, für einen Aryloxy- oder einen Arylalkoxyrest steht, oder $R^1$ und $R^2$ miteinander zu einem Ring verbunden sind;
$R^3$ für einen mindestens zweifach substituierten Phenyl-, Pyridyl-, Furyl- oder Thiophenyl-Rest steht, der mindestens an den beiden zur Verknüpfungsstelle mit der Carbonylgruppe benachbarten Kohlenstoffatomen die Substituenten A und B trägt, die untereinander gleich oder verschieden sein können, und für 1 bis 6 Kohlenstoffatome enthaltende Alkyl-, Alkoxy- oder Alkylthioreste, 5 bis 7 Kohlenstoffatome enthaltende Cycloalkylreste, Phenylreste oder Halogenatome stehen, oder $R^3$ für einen mindestens in den 2,8-Stellungen durch A und B substituierten $\alpha$-Naphthylrest oder mindestens in den 1,3-Stellungen durch A und B substituierten $\beta$-Naphthylrest steht,
sowie
X für Sauerstoff oder Schwefel steht.

**3.** Verfahren nach Anspruch 1 oder 2, dadurch gekennzeichnet, daß in der allgemeinen Formel (I) des Photooxidationsmittels (b) $R^3$ ein 2,4,6-Trimethylphenyl-, 2,3,6-Trimethylphenyl-, 2,6-Dimethoxyphenyl-, 2,6-Dichlorphenyl-, 2,6-Di-(methylthio)-phenyl- oder ein 2,3,5,6-Tetramethylphenylrest ist.

**4.** Verfahren nach einem der Ansprüche 1 oder 2, dadurch gekennzeichnet, daß $R^3$ ein 2,4,6-Trimethylpyridyl-3- oder ein 2,4-Dimethylthiophenyl-3-Rest ist.

**5.** Verfahren nach einem der Ansprüche 1 oder 2, dadurch gekennzeichnet, daß $R^3$ ein 1,3-Dimethylnaphthalin-2-, ein 2,8-Dimethylnaphthalin-1-,ein 1,3-Dimethoxy-naphthalin-2- oder ein 2,8-Dimethoxynaphthalin-1-Rest ist.

**6.** Verfahren nach einem der Ansprüche 1 bis 5, dadurch gekennzeichnet, daß $R^1$ und $R^2$ die Bedeutung Phenyl oder $C_1$- bis $C_6$-Alkyl-substituiertes Phenyl haben.

**7.** Verfahren nach einem der Ansprüche 1 bis 6, dadurch gekennzeichnet, daß als farblose oder praktisch farblose organische Verbindung (a), die zu einer farbigen Verbindung oxidierbar ist, einen Leukofarbstoff, insbesondere einen Triarylmethanfarbstoff in seiner Leukoform eingesetzt wird.

**8.** Verfahren nach einem der Ansprüche 1 bis 7, dadurch gekennzeichnet, daß als Photopolymerisationsinitiator eine aromatische Carbonylverbindung, insbesondere Benzophenon oder ein Benzophenon-Derivat, eingesetzt wird.

**9.** Verfahren nach einem der Ansprüche 1 bis 8, dadurch gekennzeichnet, daß als Sensibilisator ein tertäres aromatisches Amin eingesetzt wird, bei dem der die tertiäre Amino-Gruppe tragende aromatische Ring mit einem weiteren aromatischen Ring über Konjugation miteinander verbunden ist.

**10.** Verfahren nach Anspruch 9, dadurch gekennzeichnet, daß als Sensibilisator eine Verbindung der allgemeinen Formel (II)

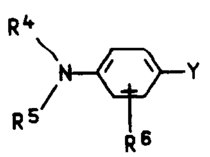

(II)

eingesetzt wird, worin
$R^4$ und $R^5$ gleich oder verschieden sein können und stehen für eine Alkylgruppe, eine Phenylgruppe, eine Aralkyl-Gruppe oder eine Hydroxyalkyl-Gruppe,
$R^6$ steht für ein Wasserstoffatom oder eine Alkylgruppe und
Y steht für einen gegebenenfalls substituierten Benzoylrest.

**11.** Verfahren zur Herstellung von photoresistschichten auf Basis von photopolymerisierbaren Aufzeichnungsmaterialien nach einem der Ansprüche 1 bis 10.

**12.** Verfahren zur Herstellung von Flachdruckplatten auf Basis von photopolymerisierbaren Aufzeichnungsmaterialien nach einem der Ansprüche 1 bis 10.

## Claims

**Claims for the following Contracting States : BE, CH, DE, FR, GB, IT, LI, NL, SE**

**1.** A photopolymerizable recording material comprising one or more photopolymerizable, olefinically unsaturated organic compounds, if necessary a polymeric binder, one or more photopolymerization initiators, a color-producing system which brings about an increase in the color intensity of the recording material on exposure to actinic light, a sensitizer and, if required, further additives or assistants, which contains, as the color-producing system,

(a) one or more colorless or virtually colorless organic compounds which can be oxidized to a colored compound and

(b) a photochemical oxidizing agent for the colorless or virtually colorless organic compound (a),

wherein said recording material contains, as the photochemical oxidizing agent (b), an acylphosphine oxide or sulfide compound, with the proviso that the maximum of the long-wavelength absorption band of this compound is at below 500 nm.

2. A photopolymerizable recording material as claimed in claim 1, which contains, as the photochemical oxidizing agent (b), an acylphosphine oxide or sulfide compound of the general formula (I)

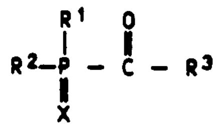

(I)

where $R^1$ is straight-chain or branched alkyl of 1 to 6 carbon atoms, cyclohexyl, cyclopentyl, aryl, halogen-, alkyl- or alkoxy-substituted aryl, an S- or N-containing five-membered or six-membered heterocyclic radical, $C_1$-$C_6$-alkoxy, $\alpha,\omega$-hydroxyalkoxy where the alkyl group is of 1 to 6 carbon atoms, aryloxy or arylalkoxy, and $R^1$ may furthermore contain C-C double bonds which make it possible to incorporate the photochemical oxidizing agent into the binder as polymerized units,
$R^2$ has the same meanings as $R^1$, and $R^1$ and $R^2$ may be identical or different, or is alkoxy of 1 to 6 carbon atoms, aryloxy or arylalkoxy, or $R^1$ and $R^2$ may be bonded to one another to form a ring;
$R^3$ is a disubstituted or polysubstituted phenyl, pyridyl, furyl or thiophenyl radical which carries, at least at the two carbon atoms adjacent to the point of bonding of the carbonyl group, substituents A and B which may be identical or different and are each alkyl, alkoxy or alkylthio of 1 to 6 carbon atoms, cycloalkyl of 5 to 7 carbon atoms, phenyl or halogen, or $R^3$ is $\alpha$-naphthyl which is substituted at least in the 2,8-positions by A and B or is $\beta$-naphthyl which is substituted at least in the 1,3-positions by A and B,
and
X is oxygen or sulfur.

3. A photopolymerizable recording material as claimed in claim 1 or 2, wherein, in the formula (I) of the photochemical oxidizing agent (b), $R^3$ is 2,4,6-trimethylphenyl, 2,3,6-trimethylphenyl, 2,6-dimethoxyphenyl, 2,6-dichlorophenyl, 2,6-di-(methylthio)-phenyl or 2,3,5,6-tetramethylphenyl.

4. A photopolymerizable recording material as claimed in claim 1 or 2, wherein $R^3$ is 2,4,6-trimethylpyrid-3-yl or 2,4-dimethylthiophen-3-yl.

5. A photopolymerizable recording material as claimed in claim 1 or 2, wherein $R^3$ is 1,3-dimethylnaphth-2-yl, 2,8-dimethylnaphth-1-yl, 1,3-dimethoxynaphth-2-yl or 2,8-dimethoxynaphth-1-yl.

6. A photopolymerizable recording material as claimed in any of claims 1 to 5, wherein $R^1$ and $R^2$ are each phenyl or $C_1$-$C_6$-alkyl-substituted phenyl.

7. A photopolymerizable recording material as claimed in any of claims 1 to 6, which contains a leuco dye, in particular a triarylmethane dye in its leuco form, as the colorless or virtually colorless organic compound (a) which can be oxidized to give a colored compound.

8. A photopolymerizable recording material as claimed in any of claims 1 to 7, which contains an aromatic carbonyl compound, in particular benzophenone or a benzophenone derivative, as the photopolymerization initiator.

9. A photopolymerizable recording material as claimed in any of claims 1 to 8, which contains, as the sensitizer, a tertiary aromatic amine in which the aromatic ring carrying the tertiary amino group is bonded to a further aromatic ring by means of conjugation.

10. A photopolymerizable recording material as claimed in claim 9, which contains, as the sensitizer, a compound of the formula (II)

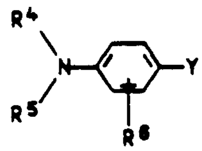

(II)

where $R^4$ and $R^5$ may be identical or different and are each alkyl, phenyl, aralkyl or hydroxyalkyl, $R^6$ is hydrogen or alkyl and Y is unsubstituted or substituted benzoyl.

**11.** A photoresist layer based on a photopolymerizable recording material as claimed in any of claims 1 to 10.

**12.** A lithographic printing plate based on a photopolymerizable recording material as claimed in any of claims 1 to 10.

**Claims for the following Contracting State : ES**

**1.** A process for the production of a photopolymerizable recording material from one or more photopolymerizable, olefinically unsaturated organic compounds, if necessary a polymeric binder, one or more photopolymerization initiators, a color-producing system which brings about an increase in the color intensity of the recording material on exposure to actinic light, a sensitizer and, if required, further additives or assistants, which contains, as the color-producing system,

(a) one or more colorless or virtually colorless organic compounds which can be oxidized to a colored compound and

(b) a photochemical oxidizing agent for the colorless or virtually colorless organic compound (a),

wherein an acylphosphine oxide or sulfide compound is used as the photochemical oxidizing agent (b), with the proviso that the maximum of the long-wavelength absorption band of this compound is at below 500 nm.

**2.** A process as claimed in claim 1, wherein the photochemical oxidizing agent (b) used is an acylphosphine oxide or sulfide compound of the formula (I)

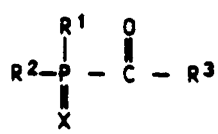

(I)

where $R^1$ is straight-chain or branched alkyl of 1 to 6 carbon atoms, cyclohexyl, cyclopentyl, aryl, halogen-, alkyl- or alkoxy-substituted aryl, an S- or N-containing five-membered or six-membered heterocyclic radical, $C_1$-$C_6$-alkoxy, $\alpha,\omega$-hydroxyalkoxy where the alkyl group is of 1 to 6 carbon atoms, aryloxy or arylalkoxy, and $R^1$ may furthermore contain C-C double bonds which make it possible to incorporate the photochemical oxidizing agent into the binder as polymerized units,

$R^2$ has the same meanings as $R^1$, and $R^1$ and $R^2$ may be identical or different, or is alkoxy of 1 to 6 carbon atoms, aryloxy or arylalkoxy, or $R^1$ and $R^2$ may be bonded to one another to form a ring;

$R^3$ is a disubstituted or polysubstituted phenyl, pyridyl, furyl or thiophenyl radical which carries, at least at the two carbon atoms adjacent to the point of bonding of the carbonyl group, substituents A and B which may be identical or different and are each alkyl, alkoxy or alkylthio of 1 to 6 carbon atoms, cycloalkyl of 5 to 7 carbon atoms, phenyl or halogen, or $R^3$ is $\alpha$-naphthyl which is substituted at least in the 2,8-positions by A and B or is $\beta$-naphthyl which is substituted at least in the 1,3-positions by A and B,

and

X is oxygen or sulfur.

**3.** A process as claimed in claim 1 or 2, wherein, in the formula (I) of the photochemical oxidizing agent (b), $R^3$ is 2,4,6-trimethylphenyl, 2,3,6-trimethylphenyl, 2,6-dimethoxyphenyl, 2,6-dichlorophenyl, 2,6-di-(methylthio)-phenyl or 2,3,5,6-tetramethylphenyl.

4. A process as claimed in claim 1 or 2, wherein $R^3$ is 2,4,6-trimethylpyrid-3-yl or 2,4-dimethylthiophen-3-yl.

5. A process as claimed in claim 1 or 2, wherein $R^3$ is 1,3-dimethylnaphth-2-yl, 2,8-dimethylnaphth-1-yl, 1,3-dimethoxynaphth-2-yl or 2,8-dimethoxynaphth-1-yl.

6. A process as claimed in any of claims 1 to 5, wherein $R^1$ and $R^2$ are each phenyl or $C_1$-$C_6$-alkyl-substituted phenyl.

7. A process as claimed in any of claims 1 to 6, wherein a leuco dye, in particular a triarylmethane dye in its leuco form, is used as the colorless or virtually colorless organic compound (a) which can be oxidized to a colored compound.

8. A process as claimed in any of claims 1 to 7, wherein an aromatic carbonyl compound, in particular benzophenone or a benzophenone derivative, is used as the photopolymerization initiator.

9. A process as claimed in any of claims 1 to 8, wherein a tertiary aromatic amine in which the aromatic ring carrying the tertiary amino group is bonded to a further aromatic ring by means of conjugation is used as the sensitizer.

10. A process as claimed in claim 9, wherein the sensitizer used is a compound of the formula (II)

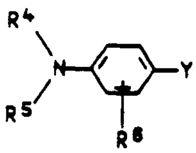

(II)

where $R^4$ and $R^5$ may be identical or different and are each alkyl, phenyl, aralkyl or hydroxyalkyl, $R^6$ is hydrogen or alkyl and Y is unsubstituted or substituted benzoyl.

11. A process for the production of a photoresist layer based on a photopolymerizable recording material as claimed in any of claims 1 to 10.

12. A process for the production of a lithographic printing plate based on a photopolymerizable recording material as claimed in any of claims 1 to 10.

**Revendications**

**Revendications pour les Etats contractants suivants : BE, CH, DE, FR, GB, IT, LI, NL, SE**

1. Matériaux d'enregistrement photopolymérisables comportant au moins un composé organique insaturé oléfiniquement et photopolymérisable, éventuellement un liant polymère, au moins un initiateur de photopolymérisation, un système chromogène, qui, par irradiation à la lumière actinique, engendre un accroissement de l'intensité de la couleur des matériaux d'enregistrement, un sensibilisateur ainsi éventuellement que d'autres additifs et/ou adjuvants, qui, comme système chromogène, comportent

   (a) au moins un composé organique incolore ou pratiquement incolore, qui est oxydable, pour donner un composé coloré, et

   (b) un milieu de photo-oxydation pour le composé organique incolore ou pratiquement incolore,

   caractérisés par le fait qu'ils comportent, comme milieu de photo-oxydation (b), un composé acylphosphinoxyde ou acylphosphinesulfure, sous réserve que la longueur d'onde maximale de la bande d'absorption de ce composé soit inférieure à 500 nm.

2. Matériaux d'enregistrement photopolymérisables selon la revendication 1, caractérisés par le fait qu'ils comportent, comme milieux de photo-oxydation (b), des composés d'acylphosphinoxyde ou d'acylphosphinesulfure de formule générale (I) :

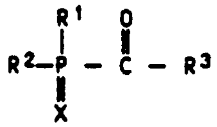

(I)

où $R^1$ représente un reste alkyle à chaîne droite ou ramifiée ayant 1 à 6 atomes de carbone, un reste aryle cyclohexyle, cyclopentyle, un reste aryle substitué par halogène, alkyle ou alcoxyle, un reste hétérocyclique à cinq ou six chaînons comportant N ou S, il représente également un reste alcoxy en C1-C6, un reste $\alpha,\omega$-hydroxyalkyloxy ayant 1 à 6 atomes de carbone dans le groupe alkyle, un reste aryloxy ou arylalcoxy, et le reste $R^1$ contient éventuellement en outre des liaisons doubles C-C-qui permettent d'introduire en polymérisation le milieu de photo-oxydation dans le liant,
$R^2$ a la signification de $R^1$,
$R^1$ et $R^2$ pouvant être identiques ou différents l'un de l'autre,
ou représente un reste alcoxy ayant 1 à 6 atomes de carbone, un reste aryloxy ou arylalcoxy,
ou $R^1$ et $R^2$ sont liés ensemble en un cycle ;
$R^3$ représente un reste phényle, pyridyle, furyle ou thiophényle au moins deux fois substitué, qui porte au moins, sur les deux atomes de carbone voisins du groupe carbonyle à l'emplacement de la liaison, les substituants A et B, qui peuvent être identiques ou différents l'un de l'autre, et qui représentent des restes alkyle, alcoxy ou alkylthio ayant 1 à 6 atomes de carbone, des restes cycloalkyle comportant 5 à 7 atomes de carbone, des restes phényles ou atomes d'halogène,
ou $R^3$ représente un reste $\alpha$-naphtyle au moins substitué par A et B dans les positions 2,8 ou un reste $\beta$-naphtyle au moins substitué par A et B dans les positions 1,3,
tandis que
x représente un oxygène ou du soufre.

**3.** Matériaux d'enregistrement photopolymérisables selon l'une des revendications 1 et 2, caractérisés par le fait que, dans la formule générale (I) du milieu de photo-oxydation, $R^3$ est un reste 2,4,6-triméthylphényle, 2,3,6-triméthylphényle, 2,6-diméthoxyphényle, 2,6-dichlorophényle, 2,6-di(méthylthio)-phényle ou un reste 2,3,5,6-tétraméthylphényle.

**4.** Matériaux d'enregistrement photopolymérisables selon l'une des revendications 1 et 2, dans lesquels $R^3$ est un reste 2,4,6-triméthylpyridyle ou 2,4-diméthylthiophényle-3.

**5.** Matériaux d'enregistrement photopolymérisables selon l'une des revendications 1 et 2, dans lesquels $R^3$ est un reste 1,3-diméthyle-naphtalène-2, un 2,8-diméthyle-naphtalène-1, 1,3-diméthoxy-naphtalène-2 ou un 2,8-diméthoxynaphtalène-1.

**6.** Matériaux d'enregistrement photopolymérisables selon l'une des revendications 1 à 5, dans lesquels $R^1$ et $R^2$ signifient phényle ou phényle substitué par alkyle en C1-C6.

**7.** Matériaux d'enregistrement photopolymérisables selon l'une des revendications 1 à 6, caractérisés par le fait qu'ils comportent, comme composé (a) organique incolore ou pratiquement incolore qui est oxydable pour donner un composé coloré, un matériau colorant leuko, en particulier un matériau colorant triarylméthane sous sa forme leuko.

**8.** Matériaux d'enregistrement photopolymérisables selon l'une des revendications 1 à 7, caractérisés par le fait qu'ils comportent, comme initiateur de photopolymérisation, un composé carbonyle aromatique, en particulier de la benzophénone ou un dérivé de la benzophénone.

**9.** Matériaux d'enregistrement photopolymérisables selon l'une des revendications 1 à 8, caractérisés par le fait qu'ils comportent, comme sensibilisateur, une amine aromatique tertiaire, avec laquelle le cycle aromatique portant le groupe amino tertiaire est lié, par conjugaison, à un autre cycle aromatique.

**10.** Matériaux d'enregistrement photopolymérisables selon la revendication 9, caractérisés par le fait qu'ils comportent, comme sensibilisateur, un composé de formule générale (II), où

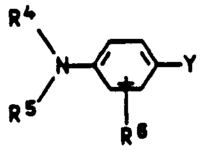

(II)

$R^4$ et $R^5$ peuvent être identiques ou différents et représentent un groupe alkyle, un groupe phényle, un groupe aralkyle ou un groupe hydroxyalkyle,
$R^6$ représente un atome d'hydrogène ou un groupe alkyle, et
Y représente un reste benzoyle éventuellement substitué.

**11.** Couches de photo réserves à base de matériaux d'enregistrement photopolymérisables selon l'une des revendications 1 à 10.

**12.** Clichés d'impression à plat à base de matériaux d'enregistrement photopolymérisables selon l'une des revendications 1 à 10.

**Revendications pour l'Etat contractant suivant : ES**

**1.** Procédé de préparation de matériaux d'enregistrement photopolymérisables comportant au moins un composé organique insaturé oléfiniquement et photopolymérisable, éventuellement un liant polymère, au moins un initiateur de photopolymérisation, un système chromogène, qui, par irradiation à la lumière actinique, engendre un accroissement de l'intensité de la couleur des matériaux d'enregistrement, un sensibilisateur ainsi éventuellement que d'autres additifs et/ou adjuvants, qui, comme système chromogène, comportent
(a) au moins un composé organique incolore ou pratiquement incolore, qui est oxydable, pour donner un composé coloré, et
(b) un milieu de photo-oxydation pour le composé organique incolore ou pratiquement incolore,
caractérisé par le fait qu'on introduit, comme milieu de photo-oxydation (b), un composé acylphosphinoxyde ou acylphosphinesulfure, sous réserve que la longueur d'onde maximale de la bande d'absorption de ce composé soit inférieure à 500 nm.

**2.** Procédé selon la revendication 1, caractérisé en ce qu'on introduit, comme milieux de photo-oxydation (b), des composés d'acylphosphinoxyde ou d'acylphosphinesulfure de formule générale (I) :

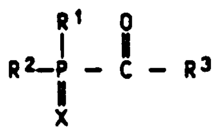

(I)

où $R^1$ représente un reste alkyle à chaîne droite ou ramifiée ayant 1 à 6 atomes de carbone, un reste aryle cyclohexyle, cyclopentyle, un reste aryle substitué par halogène, alkyle ou alcoxyle, un reste hétérocyclique à cinq ou six chaînons comportant N ou S, il représente également un reste alcoxy en C1-C6, un reste $\alpha,\omega$-hydroxyalkyloxy ayant 1 à 6 atomes de carbone dans le groupe alkyle, un reste aryloxy ou arylalcoxy, et le reste $R^1$ contient éventuellement en outre des liaisons doubles C-C- qui permettent d'introduire en polymérisation le milieu de photo-oxydation dans le liant,
$R^2$ a la signification de $R^1$,
$R^1$ et $R^2$ pouvant être identiques ou différents l'un de l'autre,
ou représente un reste alcoxy ayant 1 à 6 atomes de carbone, un reste aryloxy ou arylalcoxy,
ou $R^1$ et $R^2$ sont liés ensemble en un cycle ;
$R^3$ représente un reste phényle, pyridyle, furyle ou thiophényle au moins deux fois substitué, qui porte au moins, sur les deux atomes de carbone voisins du groupe carbonyle à l'emplacement de la liaison, les substituants A et B, qui peuvent être identiques ou différents l'un de l'autre, et qui représentent des restes alkyle, alcoxy ou alkylthio ayant 1 à 6 atomes de carbone, des restes cycloalkyle comportant 5 à 7 atomes de carbone, des restes phényles ou atomes d'halogène,
ou $R^3$ représente un reste $\alpha$-naphtyle au moins substitué par A et B dans les positions 2,8 ou un reste

β-naphtyle au moins substitué par A et B dans les positions 1,3,
tandis que
x représente un oxygène ou du soufre.

3. Procédé selon l'une des revendications 1 et 2, caractérisé par le fait que, dans la formule générale (I) du milieu de photo-oxydation, $R^3$ est un reste 2,4,6-triméthylphényle, 2,3,6-triméthylphényle, 2,6-diméthoxyphényle, 2,6-dichlorophényle, 2,6-di(méthylthio)-phényle ou un reste 2,3,5,6-tétraméthylphényle.

4. Procédé selon l'une des revendications 1 et 2, dans lequel $R^3$ est un reste 2,4,6-triméthylpyridyle ou 2,4-diméthylthiophényle-3.

5. Procédé selon l'une des revendications 1 et 2, dans lequel $R^3$ est un reste 1,3-diméthyle-naphtalène-2, un 2,8-diméthyle-naphtalène-1, 1,3-diméthoxynaphtalène-2 ou un 2,8-diméthoxynaphalène-1.

6. Procédé selon l'une des revendications 1 à 5, dans lequel $R^1$ et $R^2$ signifient phényle ou phényle substitué par alkyle en C1-C6.

7. Procédé selon l'une des revendications 1 à 6, dans lequel on introduit, comme composé (a) organique incolore ou pratiquement incolore qui est oxydable pour donner un composé coloré, un matériau colorant leuko, en particulier un matériau colorant triarylméthane sous sa forme leuko.

8. Procédé selon l'une des revendications 1 à 7, dans lequel on introduit, comme initiateur de photopolymérisation, un composé carbonyle aromatique, en particulier d'un benzophénone ou un dérivé du benzophénone.

9. Procédé selon l'une des revendications 1 à 8, dans lequel on introduit, comme sensibilisateur, une amine aromatique tertiaire, avec laquelle le cycle aromatique portant le groupe amino tertiaire est lié, par conjugaison, à un autre cycle aromatique.

10. Procédé selon la revendication 9, caractérisé par le fait qu'il comporte, comme sensibilisateur, un composé de formule générale (II), où

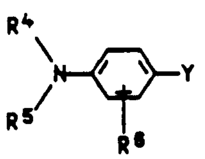

(II)

$R^4$ et $R^5$ peuvent être identiques ou différents et représentent un groupe alkyle, un groupe phényle, un groupe aralkyle ou un groupe hydroxyalkyle,
R6 représente un atome d'hydrogène ou un groupe alkyle, et
Y représente un reste benzoyle éventuellement substitué.

11. Procédé de préparation de couches de photo réserves à base de matériaux d'enregistrement photopolymérisables selon l'une des revendications 1 à 10.

12. Procédé de préparation de clichés d'impression à plat à base de matériaux d'enregistrement photopolymérisables selon l'une des revendications 1 à 10.